(19) **Europäisches Patentamt**
**European Patent Office**
**Office européen des brevets**

(11) **EP 3 757 248 B1**

(12) **EUROPEAN PATENT SPECIFICATION**

(45) Date of publication and mention
of the grant of the patent:
**13.04.2022 Bulletin 2022/15**

(51) International Patent Classification (IPC):
**C23C 14/14** (2006.01)     **C23C 14/34** (2006.01)
**C22C 19/00** (2006.01)     **C22C 19/03** (2006.01)
**H01J 37/34** (2006.01)

(21) Application number: **19182532.2**

(22) Date of filing: **26.06.2019**

(52) Cooperative Patent Classification (CPC):
**C23C 14/3414; C22C 19/007; C22C 19/03;**
**C23C 14/14; H01J 37/3426; H01J 37/3491**

(54) **NISI SPUTTERING TARGET WITH IMPROVED GRAIN STRUCTURE**

NISI-SPUTTERTARGET MIT VERBESSERTER KORNSTRUKTUR

CIBLE DE PULVÉRISATION NISI À STRUCTURE DE GRAIN AMÉLIORÉE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.12.2020 Bulletin 2020/53**

(73) Proprietor: **Materion Advanced Materials Germany
GmbH
63755 Alzenau (DE)**

(72) Inventors:
• **SCHLOTT, Martin
63075 Offenbach (DE)**
• **Konietzka, Uwe
63826 Geiselbach (DE)**

(74) Representative: **Kador & Partner PartG mbB
Corneliusstraße 15
80469 München (DE)**

(56) References cited:
**US-A1- 2006 118 407     US-B2- 6 780 295**

• **SPIEKERMANN P: "Legierungen - ein
besonderes patentrechtliches Problem?",
MITTEILUNGEN DER DEUTSCHEN
PATENTANWAELTE, HEYMANN, KOLN, DE, vol.
34, 1 January 1993 (1993-01-01), pages 178-190,
XP002152326, ISSN: 0026-6884**

**Description**

The present invention relates to a sputtering target consisting of a NiSi alloy which consists of Ni, from 2 to 8 weight% Si, optionally dopant elements in an amount of 1000 ppm or less and the remainder being unavoidable impurities.

The use of NiSi alloys as sputtering targets is known, for example, for the deposition of under-bump metallization layers, barrier layers for soldering processes, any high Ni containing layers like blocker layers in low-e stacks to protect the Ag-layer underneath form oxidation, metal mesh electrodes in touch panels and also as replacement for any other high-Ni containing nonmagnetic layer.

In particular, it is known from US 2008/0138974 that NiSi alloys with a content of 2 to 20 weight% of Si can be used as sputtering targets to deposit barrier layer films for under-bump metallization.

Furthermore, US 6,780,295 discloses about melting, casting and rolling a NiSi >4.5-50wt% alloy in order to obtain a sputtering target with at least 90% magnetic pass through flux compared to a nonmagnetic metal.

Furthermore, US 2006/0118407 A1 discloses A method for making nickel/silicon sputter targets, targets made thereby and sputtering processes using such targets. Molten nickel is blended with sufficient molten silicon and cast to form an alloy containing trace amounts, up to less than 4.39 wt % silicon, and preferably 2.0 wt % silicon.

However, the known NiSi sputtering targets could still be improved as regards their sputtering properties and the properties of the sputtered films.

Thus, it is the object of the present invention to provide a NiSi alloy based sputtering target which allows for sputtering with a high reproducibility of the sputtering rate and under high power without abnormal discharge (arcing). Furthermore, the layers/films obtained by sputtering using said target should show improved uniformity.

These objects are achieved by a sputtering target consisting of, a NiSi alloy consisting of Ni, from 2 to 8 weight% Si, optionally dopant elements in an amount of 1000 ppm or less and the remainder being unavoidable impurities, characterized in that the NiSi alloy has an average grain size of 150 to 400 $\mu$m and a grain size variation of lower than 30%.

It has been discovered by the inventors that sputtering using the target of the invention can be performed with high power of up to 20 W/cm$^2$ and that the deposited films are characterized by a high film uniformity.

In further embodiments, the NiSi alloy preferably consists of Ni and from 2.5 to 7.5 weight% Si, more preferably consists of Ni and from 2.75 to 7 weight% Si, and most preferably consists of Ni and from 3 to 6 weight% Si with the remainder being unavoidable impurities.

Optionally, the Si used for producing the alloy may contain dopants such as B, P or As in the usual amounts. The dopant(s) will then also be present in the alloy used in the sputtering target.

Thus, the NiSi alloy which consists of Ni and from 2 to 8 weight% Si, preferably consists of Ni and from 2.5 to 7.5 weight% Si, more preferably consists of Ni and from 2.75 to 7 weight% Si, and most preferably consists of Ni and from 3 to 6 weight% Si with the remainder being unavoidable impurities optionally may contain dopant elements.

For sake of clarity the term "dopant elements" designates elements which have been deliberately introduced into the Si in a defined amount, in contrast to (unavoidable) impurities.

The term "usual dopant amounts" as used herein designates amounts which preferably do not exceed 1 wt.%, more preferably do not exceed 0.5 wt.%, for each dopant element in the Si used for preparing the alloy, and more preferably designate amounts in which the total amount of all dopant elements does not exceed 1 wt., more preferably do not exceed 0.5 wt.%, in the Si used for preparing the alloy.

In the finally prepared NiSi alloy the optionally present dopant elements are each present in an amount of 1000 ppm or less, preferably of 500 ppm or less, and most preferably of 100 ppm or less, and more preferably the optionally present dopant elements are present in a total amount of 1000 ppm or less, more preferably of 500 ppm or less, and most preferably of 100 ppm or less.

The average grain size of the NiSi alloy is preferably from 175 to 375 $\mu$m, and more preferably from 200 to 350 $\mu$m.

The NiSi alloy preferably is produced by melting Ni and Si. Preferably, Ni with a purity of at least 99.9 % (3N), more preferably of at least 99.95 (3.5N), and most preferably at least 99.99 % (4N) is used for producing the alloy.

Further preferred, the Si used in producing the alloy has a purity of at least 99.99 % (4N), more preferably of 99.995 % (4.5N), and most preferably of at least 99.999 % (5N), excluding dopants.

As mentioned above, the Si feedstock may be doped with dopants such as B, P or As as defined above.

The present invention furthermore relates to a process for forming a sputtering target, preferably a sputtering target in any of the embodiments as herein described, which comprises rolling an NiSi alloy consisting of Ni, 2 to 8 weight% Si, optionally dopant elements in an amount of 1000 ppm or less, and the remainder being unavoidable impurities or a NiSi alloy in any other embodiment as described herein, and annealing it at a temperature in the range of 750 to 975 °C, wherein rolling is performed so that a total thickness reduction of 60 to 90 % is obtained.

In particular the annealing step at the prescribed temperature is important to obtain the grain sizes and grain size variation yielding the improved sputtering properties.

Rolling preferably takes place at a temperature of 1,000 to 1,250 °C.

Rolling is effected in one pass or multiple, i.e. two or more, passes, preferably multiple passes.

When using multiple rolling passes the ingot may have to be re-heated between the different passes.

Rolling is effected so that a total thickness reduction, i.e. a thickness reduction after all rolling passes have been completed, of the ingot of 60 to 90 % is obtained.

Annealing is performed at a temperature of from 750 to 975 °C, preferably at a temperature of from 800 to 950 °C, and more preferably from 825 to 940 °C.

Preferably, the annealing time is from 25 minutes to 4 hours, more preferably is from 35 minutes to 3 hours, and most preferably is from 45 minutes to 2 hours. Usually an annealing time of 1 hour will be applied.

Usually, the rolling and annealing steps are preceded by a step in which the Ni and Si are melted/cast together to form an ingot. This may be done by overheating the melt by 150 to 300 °C for casting under inert gas or in vacuum.

**Definitions/Measurement methods**

a) Grain size and grain size variation

In order to determine the grain size variation, a sputtering target of a diameter of at least 150 mm is prepared. The target is divided into 4 equal sectors by drawing 2 lines under 90° angle through the center of the plate.

Coin shaped samples with d = 1 to 2cm are taken close to the edge of the plate at each of the 4 positions where the lines exit the plate, as well as at the center of the plate where the lines intersect. These 5 samples are ground starting with 120 grit down to 2400 grit SiC based grinding paper and subsequently etched by $H_2O$ - $HNO_3$ - HCl - $H_2O_2$ (ca. 20ml - 15ml - 20ml - 10ml) on one side for about 1-2 minutes at room temperature, until a visible grain structure develops.

After evaluation of the grains sizes (see below) the procedure is repeated for the opposite side of each sample.

The grain sizes are evaluated as follows:

From each micrograph a photo is taken. The magnifications is set in a way that a line drawn over a photograph of the etched samples crosses between 8 and 30 grain boundaries.

Each micrograph is evaluated by the line intersection method (ASTM E112) and the mean grain size is calculated for each of the 10 samples. In addition the largest grain found by the method is noted for each of the 10 samples.

The average grain size M was determined by the linear intercept method according to DIN EN ISO 643 according to the following equation:

$$M=(L*p)/(N*m)$$

wherein

L: length of the measurement line
p: number of measurement line
N: number of the cut objects
m: magnification

The values were determined at 3*3=9 different measurement locations, each in three depths: 0 mm, 3 mm and 6 mm.

From the so determined grain sizes M the grain size variation can be calculated according to the following equations (as A1 value or, alternatively, as B1 value):

$$A1=(M_{max} - M_{ave})/(M_{ave} * 100)$$

$$B1 = (M_{ave} - M_{min})/(M_{ave} * 100)$$

with

Mmax: maximum grain size
$M_{min}$: minimum grain size
$M_{ave}$: average grain size

The grain size variation as herein used is defined as the higher value of the variation calculable from A1 and B1.

b) Sputtering performance

Sputtering performance was evaluated on a ZH-1000-3K sputtering machine from Onlink Technologies, Germany.

D75mmx6mm targets were machined from the rolled plates. As power supply an Advanced Energy Pinnacle+ was used.

Sputtering deposition as done as follows:

► Process pressure: $3 \times 10^{-3}$ mbar

► Ar-flow: 200sccm

► Power: Burn-in for 0.5h at 2W/cm$^2$. Afterwards continuous increase up to 20 W/cm$^2$.

Arcing was monitored on the Advanced Energy Pinnacle+ power supply with the following settings:

- Arc shutdown = 200$\mu$s

- Arc trip level = 70V

**Examples**

Several examples and comparative examples were performed in order to illustrate the invention. All target plates were manufactured by using Ni feedstock of 3N-5N purity and Si of 5N purity.

All castings were made with 30 kg of ingot material under vacuum or inert gas in an induction furnace. Casting was done by superheating the melt by 150 to 300°C into a steel or graphite mold.

As-cast billets were rolled and annealed as described below. Rolling reduction was from ingot thickness of 75 mm down to a plate thickness of 12 mm (corresponding to a thickness reduction of 84%). For annealing, a preheated air furnace was used with 1h soaking time, followed by air cooling.

After annealing, the plates were machined to a thickness of 6 mm to obtain the sputtering targets.

The obtained results are listed in Table 1 below:

Table 1:

| Example | Ni purity | Si (wt%) | Rolling T (°C) | Anneal ing (°C) | Mea n GS ($\mu$m) | GS variati on (%) | Thin film uniformity | $\mu$- Arcing |
|---|---|---|---|---|---|---|---|---|
| 1 | 4N | 3.0 | 1100 | 875 | 231 | 19.2 | Good | Low |
| 2 | 3N5 | 5.0 | 1175 | 925 | 275 | 16.0 | Very Good | Low |
| 3 | 5N | 6.0 | 1100 | 875 | 205 | 23.7 | Good | Low |
| 4 | 3N5 | 4.4 | 1050 | 850 | 212 | 20.6 | Good | Low |
| Comp 1 | 4N | 5.0 | 1050 | 700 | 135 | 45.1 | insufficient | Low |
| Comp 2 | 3N5 | 4.0 | 1100 | 1000 | 515 | 16.8 | Good | high |

**Claims**

1. Sputtering target consisting of a NiSi alloy consisting of Ni, from 2 to 8 weight% Si, optionally dopant elements in an amount of 1000 ppm or less, and the remainder being unavoidable impurities, **characterized in that** the NiSi alloy has an average grain size of 150 to 400 $\mu$m and a grain size variation of lower than 30% both measured according to the specification.

2. Sputtering target according to claim one wherein the NiSi alloy comprises from 2.5 to 7.5 weight% Si.

3. Sputtering target according to claim one or two wherein the NiSi alloy comprises from 2.75 to 6.5 weight% Si.

4. Sputtering target according to any one of the preceding claims wherein the NiSi alloy comprises from 3 to 6 weight% Si.

5. Sputtering target according to any one of the preceding claims wherein the NiSi alloy is having an average grain size of 175 to 375 $\mu$m measured according to the specification.

6. Sputtering target according to any one of the preceding claims wherein the NiSi alloy is having an average grain size of 200 to 350 $\mu$m measured according to the specification.

7. Sputtering target according to any one of the preceding claims wherein the alloy has been produced by melting Ni and Si and using Ni with a purity of at least 99.9% (3N).

8. Process for forming sputtering target **characterized in that** an NiSi alloy consisting of Ni, 2 to 8 weight% Si, optionally dopant elements in an amount of 1000 ppm or less, and the remainder being unavoidable impurities, is rolled and annealed at a temperature of 750 to 975 °C, wherein rolling is performed so that a total thickness reduction of 60 to 90 % is obtained.

9. Process according to claim 8 wherein annealing is performed at a temperature of 800 to 950 °C.

10. Process according to claim 9, wherein annealing is performed at a temperature of 825 to 940 °C.

11. Process according to any one of claims 8 to 10, wherein rolling is performed at a temperature of 1,000 to 1,250 °C.


**Patentansprüche**

1. Sputtertarget, bestehend aus einer NiSi-Legierung, bestehend aus Ni, 2 bis 8 Gew.-% Si, wahlweise Dotierungselementen in einer Menge von 1000 ppm oder weniger, wobei der Rest unvermeidbare Verunreinigungen sind, **dadurch gekennzeichnet, dass** die NiSi-Legierung eine durchschnittliche Korngröße von 150 bis 400 $\mu$m und eine Korngrößenschwankung von weniger als 30 % aufweist, beide gemessen entsprechend der Beschreibung.

2. Sputtertarget nach Anspruch 1, wobei die NiSi-Legierung 2,5 bis 7,5 Gew.-% Si umfasst.

3. Sputtertarget nach Anspruch 1 oder 2, wobei die NiSi-Legierung 2,75 bis 6,5 Gew.-% Si umfasst.

4. Sputtertarget nach einem der vorangegangenen Ansprüche, wobei die NiSi-Legierung 3 bis 6 Gew.-% Si umfasst.

5. Sputtertarget nach einem der vorangegangenen Ansprüche, wobei die NiSi-Legierung eine durchschnittliche Korngröße von 175 bis 375 $\mu$m aufweist, gemessen entsprechend der Beschreibung.

6. Sputtertarget nach einem der vorangegangenen Ansprüche, wobei die NiSi-Legierung eine durchschnittliche Korngröße von 200 bis 350 $\mu$m aufweist, gemessen entsprechend der Beschreibung.

7. Sputtertarget nach einem der vorangegangenen Ansprüche, wobei die Legierung durch Schmelzen von Ni und Si und unter Verwendung von Ni mit einem Reinheitsgrad von zumindest 99,9 % (3N) hergestellt worden ist.

8. Verfahren zur Herstellung eines Sputtertargets, **dadurch gekennzeichnet, dass** eine NiSi-Legierung, bestehend aus Ni, 2 bis 8 Gew.-% Si, wahlweise Dotierungselementen in einer Menge von 1000 ppm oder weniger, wobei der Rest unvermeidbare Verunreinigungen sind, gewalzt und bei einer Temperatur von 750 bis 975 °C geglüht wird, wobei das Walzen so durchgeführt wird, dass eine Gesamtdickenreduzierung von 60 bis 90 % erreicht wird.

9. Verfahren nach Anspruch 8, wobei das Glühen bei einer Temperatur von 800 bis 950 °C durchgeführt wird.

10. Verfahren nach Anspruch 9, wobei das Glühen bei einer Temperatur von 825 bis 940 °C durchgeführt wird.

11. Verfahren nach einem der Ansprüche 8 bis 10, wobei das Walzen bei einer Temperatur von 1000 bis 1250 °C durchgeführt wird.

**Revendications**

1. Cible de pulvérisation constituée d'un alliage NiSi composé de Ni, de 2 à 8 % en poids de Si, éventuellement d'éléments dopants en une quantité de 1 000 ppm ou moins, et le reste étant des impuretés inévitables, **caractérisée en ce que** l'alliage NiSi a une taille de grain moyenne de 150 à 400 μm et une variation de taille de grain inférieure à 30 %, toutes deux mesurées conformément à la spécification.

2. Cible de pulvérisation selon la revendication 1, dans laquelle l'alliage NiSi comprend de 2,5 à 7,5 % en poids de Si.

3. Cible de pulvérisation selon la revendication 1 ou 2, dans laquelle l'alliage NiSi comprend de 2,75 à 6,5 % en poids de Si.

4. Cible de pulvérisation selon l'une quelconque des revendications précédentes, dans laquelle l'alliage NiSi comprend de 3 à 6 % en poids de Si.

5. Cible de pulvérisation selon l'une quelconque des revendications précédentes, dans laquelle l'alliage NiSi présente une taille de grain moyenne de 175 à 375 μm mesurée conformément à la spécification.

6. Cible de pulvérisation selon l'une quelconque des revendications précédentes, dans laquelle l'alliage NiSi présente une taille de grain moyenne de 200 à 350 μm mesurée conformément à la spécification.

7. Cible de pulvérisation selon l'une quelconque des revendications précédentes, dans laquelle l'alliage a été produit par fusion de Ni et de Si et par utilisation de Ni avec une pureté d'au moins 99,9 % (3N).

8. Procédé de formation d'une cible de pulvérisation, **caractérisé en ce qu'**un alliage NiSi constitué de Ni, de 2 à 8 % en poids de Si, éventuellement d'éléments dopants en une quantité de 1 000 ppm ou moins, et le reste étant des impuretés inévitables, est laminé et recuit à une température de 750 à 975 °C, le laminage étant effectué de manière à obtenir une réduction totale de l'épaisseur de 60 à 90 %.

9. Procédé selon la revendication 8, dans lequel le recuit est effectué à une température de 800 à 950 °C.

10. Procédé selon la revendication 9, dans lequel le recuit est effectué à une température de 825 à 940 °C.

11. Procédé selon l'une quelconque des revendications 8 à 10, dans lequel le laminage est effectué à une température de 1 000 à 1 250 °C.

**EP 3 757 248 B1**

**REFERENCES CITED IN THE DESCRIPTION**

**Patent documents cited in the description**

- US 20080138974 A
- US 6780295 B
- US 20060118407 A1